Europäisches Patentamt

European Patent Office

Office européen des brevets

(11) Veröffentlichungsnummer: **0 155 620 B1**

# EUROPÄISCHE PATENTSCHRIFT

(45) Veröffentlichungstag der Patentschrift: **22.01.92**

(21) Anmeldenummer: **85102780.5**

(22) Anmeldetag: **12.03.85**

(51) Int. Cl.⁵: **G03F 7/26**, B41N 3/08

(54) Einbrenngummierung für Offsetdruckplatten und Verfahren zur Herstellung einer Offsetdruckform.

(30) Priorität: **22.03.84 DE 3410522**

(43) Veröffentlichungstag der Anmeldung:
**25.09.85 Patentblatt 85/39**

(45) Bekanntmachung des Hinweises auf die
Patenterteilung:
**22.01.92 Patentblatt 92/04**

(84) Benannte Vertragsstaaten:
**AT BE CH DE FR GB IT LI NL**

(56) Entgegenhaltungen:
FR-A- 2 316 636      GB-A- 2 099 371
US-A- 3 257 941      US-A- 3 745 011
US-A- 4 260 422      US-A- 4 329 422
US-A- 4 572 889

(73) Patentinhaber: **HOECHST AKTIENGESELL-
SCHAFT
Postfach 80 03 20
W-6230 Frankfurt am Main 80(DE)**

(72) Erfinder: **Stahlhofen, Paul, Dr., Dipl.-Chem.
Leibnitzstrasse 18b
W-6200 Wiesbaden(DE)**
Erfinder: **Schell, Loni, Dipl.-Chem.
Erbacher Strasse 10
W-6238 Hofheim-Wallau(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine Einbrenngummierung für bestrahlte und entwickelte Offsetdruckplatten und ein Verfahren zur Herstellung einer Offsetdruckform, bei dem diese Einbrenngummierung zwischen den Stufen des Entwickelns und des Einbrennens angewendet wird.

Offsetdruckplatten bestehen im allgemeinen aus a) einem flächigen Trägermaterial aus Metallen und/oder Kunststoffen, deren Oberfläche beispielsweise durch Aufrauhen (Ätzen) und/oder anodische Oxidation modifiziert werden kann, und b) mindestens einer strahlungs(licht)empfindlichen Beschichtung (Reproduktionsschicht). Insbesondere bei positiv-arbeitenden Reproduktionsschichten, aber grundsätzlich möglich auch bei negativ-arbeitenden Reproduktionsschichten, wird bei der Herstellung einer Druckform mit den Grundarbeitsstufen Bestrahlen, Entwickeln und Gummieren (Konservieren, Desensibilisieren) zwischen den beiden letzten Stufen auch noch eine Einbrennstufe durchgeführt. Angewendet auf positiv-arbeitende Reproduktionsschichten kann man sich die Vorgehweise wie folgt vorstellen: Bei der bildmäßigen Bestrahlung (Belichtung) werden die von elektromagnetischer Energie (dem Licht) getroffenen Teile der Reproduktionsschicht löslich, die nicht getroffenen Teile bleiben unlöslich (jeweils bezogen auf den zu verwendenden Entwickler). Durch das Herauslösen der erstgenannten Teile in der Entwicklungsstufe entstehen auf der Druckplattenoberfläche nach dem Entwickeln der bestrahlten Reproduktionsschicht die beim späteren Drucken von der Druckform wasserführenden Nichtbildstellen und aus den letztgenannten Teilen die beim späteren Drucken farbführenden Bildstellen. In der Praxis hat es sich herausgestellt, daß eine Erhitzung der bestrahlten und entwickelten Druckplatte - je nach Art des Trägermaterials und/oder der Reproduktionsschicht auf mehr als 80 °C, insbesondere auf mehr als etwa 150 °C - von der Seite der Reproduktionsschicht oder auch von der Rückseite her zu höheren Druckauflagen mit der daraus resultierenden Druckform führen kann; dieser Vorgang wird als "Einbrennen" bezeichnet. Durch das Einbrennen wird eine Verfestigung der Bildstellen erreicht, wobei diese beispielsweise unlöslich in den üblichen organischen Lösemitteln und resistent gegen die Einwirkung von Chemikalien werden, wie sie beim späteren Drucken in der Druckfarbe oder dem Feuchtwasser vorhanden sein können.

Da beim Einbrennen auch Bestandteile der Bildstellen (d. h. der Reproduktionsschicht), z. B. Bestandteile des Bindemittels, in die Nichtbildstellen gelangen können und damit deren Hydrophilie negativ beeinflussen, was beispielsweise zum Tonen (Annahme von Druckfarbe in den Nichtbildstellen) führt, mußten in der Anfangsphase des Einsatzes einer Einbrennstufe die Verunreinigungen in den Nichtbildstellen mit relativ aggressiven Lösungen wieder entfernt werden. Im Laufe der Entwicklung wurden dann sogenannte "Einbrennhilfen" entwickelt, welche diese Nachreinigung zumindest erleichterten, aber im Regelfalle doch noch eine Reinigung der Nichtbildstellen mit Wasser vor dem eigentlichen Druckvorgang erforderlich machten. Zu den aus dem Stand der Technik bekannten Einbrennhilfen zählen u.a. die folgenden:

In der DE-C 23 18 286 (entspricht inhaltlich der US-A 3 745 011) wird ein Verfahren zur Herstellung negativer Resistbilder beschrieben, bei dem ein Photoresist nach dem Belichten, Entwickeln und vor einem Einbrennprozeß mit einer Lösung einer cycloaliphatischen, heterocyclischen oder aromatischen Polycarbonsäure oder einer aromatischen Sulfonsäure behandelt wird. Die lichtempfindlichen Schichten der eingesetzten Photoresists enthalten natürliche Proteine wie Fischleim und Ammoniumbichromat. Diese Behandlung vor dem Einbrennen soll a) die Einbrenntemperatur erniedrigen, b) die Ätzmittelbeständigkeit des Resistbildes erhöhen und c) die Entschichtbarkeit des Resistbildes bzw. des aufgebrachten Photoresists verbessern. Zu den eingesetzten Säuren zählen u.a. auch p-Toluolsulfonsäure, 2-Naphthalinsulfonsäure, Naphthalin-1,8-disulfonsäure, Benzolsulfonsäure und 1,3-Benzoldisulfonsäure, die vorzugsweise in 1- bis 25%iger Lösung eingesetzt werden. Als Trägermatrial für die Beschichtung mit Photoresist wird ausschließlich Stahl verwendet. Das Anwendungsgebiet Druckplatten und die dortige spezielle Einbrennproblematik werden nicht erwähnt.

Aus der DE-C 25 30 422 (= GB-A 1 513 368) ist ein Verfahren zum Herstellen von Druckformen, Platten für gedruckte Schaltungen, integrierte Schaltkreise und dgl. bekannt, bei dem die belichteten und entwickelten Schichtträger vor dem Einbrennen zumindest auf den Nichtbildstellen mit einer Schutzschicht versehen werden. Diese Schutzschicht verbleibt während des Einbrennens auf dem Schichtträger und ist nach dem Einbrennen zusammen mit einem Niederschlag, der sich während des Einbrennens auf der Schutzschicht absetzt, mit Wasser entfernbar. Die Schutzschicht wird in Form einer etwa 2,5- bis 45%igen wäßrigen Lösung einer der folgenden Verbindungen aufgebracht: Na-dodecylphenoxybenzoldisulfonat, Na-Salz einer alkylierten Naphthalinsulfonsäure, Di-Na-methylendinaphthalindisulfonat, Na-dodecyl-benzolsulfonat Na-Salz eines sulfonierten Alkyldiphenyloxids, $NH_4$-perfluoralkylsulfonat, K-perfluoralkylsulfonat, Na-dioctylsulfosuccinat, Na-di(methylamyl)-sulfosuccinat und $LiNO_3$. In der auf diese Veröffentlichung zurückgehenden GB-A 1 575 200 wird vor dem Einbrennen zusätzlich zu einer der vorstehend aufgeführten Verbindungen noch ein wasserlösliches Hydrokolloid aus der Gruppe Gummi arabicum, Na-carboxymethylcellulose oder Alginat der wäßrigen Lösung zur Erzeugung der Schutzschicht beigefügt. Das eingesetzte Stoffgemisch soll zu 85 bis 98 Vol.-% aus einer der aus der vorstehenden DE-C bekannten Verbindungen und zu 2 bis 15 Vol.-% aus einem der Hydrokolloide bestehen und wird in 10 bis 50 vol.-%iger wäßriger Lösung eingesetzt. Nach dem Einbrennen werden die Druckformen mit Wasser gewaschen und können dann in eine Druckmaschine eingespannt werden.

Das eingesetzte Gemisch könnte als eine "Einbrenngummierung" oder als ein "Einbrennkonservierungsmittel" bezeichnet werden, da es sowohl als "Einbrennhilfe" als auch als "Gummierung" wirkt.

Die Einbrennhilfe gemäß der DE-C 26 25 336 (= US-A 4 063 507) ist Borsäure oder ein Borat und wird in fester Form oder vorzugsweise in 3- bis 10%iger wäßriger Lösung eingesetzt. Nach der DE-A 26 26 473 (= GB-A 1 555 233) können anstelle der bereits vorstehend als geeignet für das Einbrennen von Druckplatten beschriebenen Verbindungen (Einbrennhilfen) u.a. auch noch verschiedene hydrophile Polymere wie Gummi arabicum, Dextrin, Polyvinylalkohol, Celluloseether, Homo- und Mischpolymerisate auf der Basis von Acryl- oder Methacrylsäure oder ein Mischpolymerisat aus Alkylacrylat und Vinylmethylacetamid oder auch Salze organischer Säuren wie Di-Na-anthrachinon-2,7-disulfonat, Tri-Na-naphthalin-1,3,5-trisulfonat, Tri-Na-1-naphthylamin-4,6,8-trisulfonat oder Tri-Na-1-naphthol-3,6,8-trisulfonat eingesetzt werden. Die Verbindungen werden in wäßriger Lösung einer Konzentration von 0,1 % bis zur Sättigung angewandt.

Als weitere Einbrennhilfen werden in der EP-A 0 043 991 (= US-A 4 355 096) Carboxylgruppen enthaltende Amine wie Ethylendiamintetraessigsäure, Nitrilotriessigsäure oder -deren Salze und in der US-A 4 191 570 Salze oder salzartige Reaktionsprodukte aus Naphthalin, Formaldehyd und Schwefelsäure aufgeführt.

Die bekannten Einbrennhilfen weisen aber alle noch mehr oder weniger große Nachteile auf. Beispielsweise können sie bei den Bildstellen eine Reduzierung der Oleophilie bewirken, sie können zu Fleckenbildung auf der Druckplattenoberfläche und - insbesondere bei ungenügender Nachreinigung mit Wasser oder wäßrigen Entwicklerlösungen - zu Störungen des Wasser/Druckfarbe-Gleichgewichts beim späteren Drucken führen. In vielen Arbeitsanweisungen zur Anwendung der bekannten Einbrennhilfen wird speziell auf diese Problematik hingewiesen, die beispielsweise durch Trockenreiben der Druckplattenoberfläche vor dem Einbrennen, sorgfältiges Nachwaschen oder auch [beispielsweise EP-B 0 012 956 (= US-A 4 265 999)] hydrophilierendes Nachbehandeln/Reinigen mit einer wäßrigen Lösung eines hydrophilen Polymeren wie Polyvinylphosphonsäure behebbar sein soll. Solche speziellen hydrophilierenden oder auch eine der üblichen gummierenden (konservierenden) Nachbehandlungen sind prinzipiell möglich, erfordern aber bei der Herstellung und Anwendung einer Druckform einen zusätzlichen Arbeitsschritt. Eine Kombination beider Schritte in einer Einbrenngummierung wird zwar in der weiter oben dargestellten GB-A 1 575 200 beschrieben, sie führt jedoch immer noch zu einem großen Papierverbrauch in der Druckmaschine, da sich - ohne eine zusätzliche Zwischenreinigung - die Druckform zu langsam freiläuft (siehe auch Vergleichsversuche weiter unten).

Aufgabe der vorliegenden Erfindung ist es deshalb, eine Einbrenngummierung für Offsetdruckplatten vorzuschlagen, die von der damit behandelten Druckform nach dem Einbrennen nicht mehr abgewaschen werden muß, beim Drucken sehr schnell zu einem Freilaufen der Druckform führt und eine gute Lagerfähigkeit aufweist bzw. deren gummierende Wirkung auch nach längerer Lagerzeit nicht erneuert oder aufgefrischt werden muß.

Die Erfindung geht aus von einer Einbrenngummierung für bestrahlte und entwickelte Offsetdruckplatten mit einem Gehalt an a) Wasser, b) mindestens einem hydrophilen Polymeren und c) mindestens einer sich von einer organischen Säure ableitenden Komponente. Die erfindungsgemäße Einbrenngummierung ist dann dadurch gekennzeichnet, daß sie als Komponente c) mindestens eine wasserlösliche organische Carbon-, Sulfon- oder Phosphonsäure mit mindestens zwei Säurefunktionen aus der Gruppe Benzolcarbonsäuren, -sulfonsäuren, -phosphonsäuren und Alkanphosphonsäuren oder eines ihrer wasserlöslichen Salze enthält.

Eine weitere Lösung der gestellten Aufgabe ist auch ein Verfahren zur Herstellung einer Offsetdruckform mit den Grundarbeitsstufen Bestrahlen, Entwickeln und Einbrennen einer Offsetdruckplatte, bei dem nach dem Entwickeln und vor dem Einbrennen eine Behandlungsstufe mit einer solchen wäßrigen Lösung zwischengeschaltet wird, die die vorstehenden Komponenten a) bis c) enthält. Ein solches Verfahren faßt von der Wirkung her die beiden Stufen Einbrennen und Konservieren (Gummieren) zu einer Stufe zusammen.

Die in der wäßrigen Lösung gelösten Komponenten b) und c) sind von solcher Art, daß sie sich bei den üblichen Einbrenntemperaturen nicht verflüchtigen. Die entstehende Schutzschicht bleibt auch nach dem Einbrennen wasserlöslich und läßt sich leicht wieder entfernen, ohne daß es zu einer Schädigung der Druckform kommt. Bei der Anwendung der Einbrenngummierung kann so verfahren werden, daß man die Oberfläche oder - bei doppelter Beschichtung mit einer Reproduktionsschicht - beide Oberflächen der bestrahlten und entwickelten Offsetdruckplatte mit einem Tampon einreibt, der mit. der Einbrenngummierung getränkt wurde; es sind auch andere Arten des Aufbringens wie Tauchen, Aufsprühen, Aufschleudern oder Aufgießen möglich, wobei dies sowohl von Hand als auch in automatischen Verarbeitungsmaschinen durchgeführt weden kann. Zweckmäßig wird die Oberfläche der mit der Einbrenngummierung versehenen Druckplatte vor dem Einbrennen getrocknet. Das Trocknen kann aber auch während des nachfolgenden Einbrennens erfolgen. Das Schichtgewicht der Einbrenngummierung liege nach dem Trocknen im allgemeinen im Bereich von 0,05 bis 20 $g/m^2$. Die so behandelte Druckplatte wird anschließend in einem Einbrennofen bei einer Temperatur von 80 bis 300 $^\circ$C, insbesondere von 150 bis 270 $^\circ$C eingebrannt, wobei übliche Einbrennzeiten bei 0,5 bis 10 min liegen. Neben den in der Praxis eingesetzten Heißluftöfen sind in jüngerer Zeit auch andere Behandlungsarten beschrieben worden, beispielsweise eine Bestrahlung mit Quarz-Halogen-Lampen gemäß der DE-C 19 55 378, mit Infrarot-Strahlung gemäß der DE-C 22 01 936 oder mit UV-Lampen gemäß der DE-A 31 10 632.

Zu der Komponente b) zählen insbesondere die hydrophilen Polymeren N-Polyvinyl-pyrrolidon-(2), Polyvinylmethylether, Copolymerisate mit einem Gehalt an Ethylen- und Maleinsäureanhydrideinheiten, Homo- oder Copolymerisate mit einem Gehalt an Vinylphosphonsäure-, Vinylmethylphosphinsäure- und/oder Acrylsäureeinheiten und/oder ein Polyalkylenglykol wie Polyethylenglykol. Zu der Komponente c) zählen insbesondere Benzoldisulfonsäuren, Benzolpolycarbonsäuren mit 3 bis 6 Carboxylgruppen, Alkandiphosphonsäuren von $C_1$ bis $C_3$, Carboxylgruppen aufweisende Alkandiphosphonsäuren von $C_5$ bis $C_9$ und/oder eines ihrer wasserlöslichen Salze (bevorzugt Alkalimetall- oder Ammoniumsalze). Beispiele für die letztgenannten Verbindungen sind Benzol-1,3-disulfonsäure, Benzol-1,2,4-tricarbonsäure (Trimellithsäure), Benzol-1,2,4,5-tetracarbonsäure (Pyromellithsäure), Benzol-hexacarbonsäure (Mellithsäure), Methandiphosphonsäure (Diphosphonomethan), 4,4-Diphosphono-heptan-1,7-disäure (3,3-Diphosphono-pimelinsäure) und/oder eines ihrer Natriumsalze. Die Einbrenngummierung enthält im allgemeinen 1 bis 50 %, bevorzugt 3 bis 30 % der Summe der Komponenten b) und c), sie enthält diese Komponenten insbesondere im Gewichtsverhältnis b):c) im Bereich von 1:1 bis 1:20.

In verschiedenen Varianten kann die Einbrenngummierung auch noch Hydroxypolycarbonsäuren wie Citronensäure und/oder deren Salze in einem Anteil von 0,1 bis 5 %, wasserlösliche Alkandiole mit mindestens 4 C-Atomen wie Hexandiol-(1,6) in einem Anteil von 0,1 bis 5 % und Tenside (bevorzugt anionogene oder nichtionogene Tenside) wie Alkylarylsulfonate (z. B. Di-Na-diisobutyl-naphthalin-disulfonat), Alkylphenolethersulfonate (z. B. Di-Na-dodecyl-diphenylether-disulfonat) oder ein natürliches Tensid (z. B. Saponin) in einem Anteil von 0,005 bis 5 % enthalten.

Mit der erfindungsgemäßen Einbrenngummierung lassen sich die üblichen in der Praxis anzutreffenden Offsetdruckplatten aus Metall und/oder temperaturstabilem Kunststoff behandeln, insbesondere ist sie jedoch geeignet für solche Offsetdruckplatten, die ein mechanisch, chemisch und/oder elektrochemisch aufgerauhtes und gegebenenfalls anodisch oxidiertes Trägermaterial aus Aluminium oder einer seiner Legierungen aufweisen. Diese Trägermaterialien können negativ- oder positivarbeitende Reproduktionsschichten tragen, die eine der bekannten strahlungsempfindlichen Verbindungen wie Diazo-, Diazonium- oder Azidoverbindungen oder photopolymerisierbare Verbindungen enthalten (siehe z.B. in Jaromir Kosar, "Light-Sensitive Systems", John Wiley & Sons, New York, 1965). Insbesondere ist die erfindungsgemäße Einbrenngummierung aber für positiv-arbeitende Reproduktionsschichten geeignet, die im allgemeinen neben der eigentlichen strahlungsempfindlichen Verbindung noch Harze, insbesondere Novolake oder Resole, aber auch verschiedene weitere Komponenten wie Farbstoffe, Haftvermittler oder Verlaufmittel enthalten. Zu den strahlungsempfindlichen Verbindungen in diesen Reproduktionsschichten zählen insbesondere die o-Chinondiazide, bevorzugt o-Naphthochinondiazide wie Naphthochinon-(1,2)-diazid-(2)sulfonsäureester oder -amide, die nieder- oder höhermolekular sein können, siehe dazu beispielsweise die DE-C 854 890, 865 109, 879 203, 894 959, 938 233, 11 09 521, 11 44 705, 11 18 606, 11 20 273, 11 24 817 und 23 31 377 und die EP-A 0 021 428 und 0 055 814.

Die erfindungsgemäße Einbrenngummierung und das erfindungsgemäße Einbrenn- und Gummierungsverfahren bewirken den von den Einbrennhilfen her bekannten Effekt einer leichten Entfernungsmöglichkeit der Verunreinigung in den Nichtbildstellen von Offsetdruckplatten. Zusätzlich machen sie aber ein Abwaschen der aufgebrachten Schutzschicht und/oder ein Auftragen oder Erneuern/Auffrischen einer Gummierung (Konservierung) überflüssig. Eine mit der beanspruchten Einbrenngummierung versehene Druckform läuft sich in der Druckmaschine in überraschend kurzer Zeit frei und gewährleistet eine schnelle Farbannahme der Bildstellen bei gleichzeitiger Tonfreiheit der Nichtbildstellen.

In der vorstehenden Beschreibung und den nachfolgenden Beispielen bedeuten %-Angaben, wenn nichts anderes angegeben ist, immer Gew.-%, Gew.-Teile stehen zu Vol.-Teilen im Verhältnis von g zu $cm^3$.

Beispiel 1

Mit einem positiv-arbeitenden strahlungsempfindlichen Gemisch aus

1,00 Gew.-Teilen

des Kondensationsproduktes aus 2,3,4-Trihydroxybenzophenon und Naphthochinon-(1,2)-diazid-(2)-5-sulfonsäurechlorid,

0,60 Gew.-Teilen

des Kondensationsproduktes aus 1 Mol 2,2'-Dihydroxy-1,1'-dinaphthylmethan und 2 Mol Naphthochinon-(1,2)-diazid-(2)-5-sulfonsäurechlorid,

6,60 Gew.-Teilen

eines durch Kondensation eines technischen Kresolgemisches mit Formaldehyd hergestellten Novolaks vom Schmelzpunkt 108 bis 118 °C,

0,08 Gew.-Teilen

Kristallviolett,

0,06 Gew.-Teilen

Sudangelb GGN in

100,00 Vol.-Teilen

Ethylenglykolmonomethylether

wird eine mechanisch aufgerauhte Aluminiumfolie, unter Verwendung einer rotierenden Unterlage zum Abschleudern der überschüssigen Menge des aufgebrachten Gemisches beschichtet. Danach wird die Folie in einem warmen Luftstrom und anschließend während etwa 5 min bei 100 °C getrocknet. Die so hergestellte Offsetdruckplatte mit einem Gewicht der Reproduktionsschicht von 2,30 $g/m^2$ wird unter einer transparenten Positivvorlage bildmäßig belichtet und anschließend mit der folgenden Lösung entwickelt:

5,3 Gew.-Teile $Na_2SiO_3 \cdot 9\ H_2O$
3,4 Gew.-Teile $Na_3PO_4 \cdot 12\ H_2O$
0,3 Gew.-Teile $NaH_2PO_4$ wasserfrei in
91,0 Gew.-Teilen $H_2O$.

Durch die Entwicklung werden die vom Licht getroffenen Anteile der Reproduktionsschicht entfernt, und es bleiben die unbelichteten Teile als Bildstellen auf dem Trägermaterial zurück, so daß eine der Vorlage entsprechende Druckschablone erhalten wird. Von einer so hergestellten Druckform können in einer Druckmaschine etwa 50.000 einwandfreie Drucke erhalten werden. Um ein Mehrfaches dieser Auflagenhöhe zu erreichen, muß die Druckplatte noch in an sich bekannter Weise eingebrannt werden. Zu diesem Zweck wird die belichtete und entwickelte Druckplatte mit Hilfe eines Tampons mit der folgenden Lösung überwischt und trockengerieben, wobei man darauf achtet, daß ein über die gesamte Oberfläche der Druckform zusammenhängender Film gebildet wird.

2,00 Gew.-Teile

N-Polyvinylpyrrolidon-(2),

10,00 Gew.-Teile

Na-benzol-1,3-disulfonat,

4,00 Gew.-Teile

Trikaliumcitrat $\cdot$ $H_2O$,

1,10 Gew.-Teile

Citronensäure $\cdot$ $H_2O$,

1,50 Gew.-Teile

Hexandiol-(1,6),

81,40 Gew.-Teile

$H_2O$ dest.

Anschließend wird die mit der Schutzschicht versehene Druckform während 5 min bei 240 °C in einem handelsüblichen Heißluftofen eingebrannt. Die so hergestellte Druckform kann sofort in die Druckmaschine eingespannt und dem üblichen Druckvorgang unterworfen werden, ohne daß es erforderlich ist, die Schutzschicht vorher mit Wasser zu entfernen und/oder die Druckformgegebenenfalls erneut mit einem Konservierungsmittel, wie beispielsweise Gummi arabicum, zu behandeln. Bereits nach 6 bis 7 Umläufen der Feucht- und Farbwalzen der Druckmaschine wird eine vollständige Farbannahme der Druckschablone bei gleichzeitiger Tonfreiheit des Hintergrundes erreicht, so daß nach spätestens 10 Bogen Papier ("Makulatur") ein einwandfreier Druck erhalten wird.

Wird unter gleichen Versuchsbedingungen eine entsprechend Beispiel 1 hergestellte vorsensibilisierte Offsetdruckplatte vor dem Einbrennen mit einer wäßrigen Lösung aus 7 % Gummi arabicum und 22 % Di-Na-dodecylphenoxybenzoldisulfonat nach Beispiel 1 der GB-A 1 575 200 behandelt und die so vorbehandelte Druckplatte eingebrannt und ohne Abwaschen der Schutzschicht in die Druckmaschine eingespannt, so wird auch nach dem Durchlaufenlassen von 100 Bogen Papier noch kein einwandfreier Andruck erhalten. Ein ähnlich unbefriedigendes Resultat wird erhalten, wenn anstelle von Gummi arabicum Na-carboxymethylcellulose verwendet wird.

Auch nach der DE-A 26 26 473 oder DE-C 26 25 336 mit beispielsweise $Na_2B_4O_7$ oder $Na_2HPO_4$ als Einbrennhilfe hergestellte Druckformen können keinen einwandfreien Andruck ergeben, wenn die entsprechenden Schutzschichten nicht vor dem eigentlichen Druckvorgang mit Wasser abgewaschen werden.

Die mit der erfindungsgemäßen Einbrenngummierung versehene eingebrannte Druckplatte kann auch über einen Zeitraum von mehreren Monaten bei Raumtemperatur gelagert werden, ohne daß bei einem später eingeleiteten Druckvorgang Nachteile, wie z. B. auftretender Ton an den bildfreien Flächen, eintreten.

Beispiele 2 bis 5

In den folgenden Beispielen werden weitere Einbrenngummierungen angegeben, mit denen die nach Beispiel 1 hergestellte Druckplatte vor dem Einbrennen behandelt wird, wobei ähnlich wie im Beispiel 1 in relativ kurzer Zeit in der Druckmaschine ein einwandfreier Druck erhalten wird. Wenn nicht gesondert vermerkt, entsprechen Herstellung und Verarbeitung der damit erhaltenen Druckplatten den in Beispiel 1 beschriebenen Bedingungen.

Beispiel 2

Es wird folgende Einbrenngummierung eingesetzt:

1,50 Gew.-Teile
Polyvinylmethylether,
3,00 Gew.-Teile
3,3-Diphosphonopimelinsäure,
7,00 Gew.-Teile
Di-Na-benzol-1,3-disulfonat,
4,00 Gew.-Teile
Trikaliumcitrat $\cdot$ $H_2O$,
1,10 Gew.-Teile
Citronensäure $\cdot$ $H_2O$,
1,50 Gew.-Teile
Hexandiol-(1,6),
0,05 Gew.-Teile
anionogenes Tensid (Na-Salz der 1,2-Isopropylnaphthalinsulfonsäure),
81,00 Gew.-Teile
$H_2O$ dest.

Beispiel 3

Es wird folgende Einbrenngummierung eingesetzt:

1,50 Gew.-Teile
einer 40%igen wäßrigen Lösung einer Polyacrylsäure mit einem Molgewicht von weniger als 150000 und einem pH-Wert von 2 ± 0,5,
4,00 Gew.-Teile
Trikaliumcitrat $\cdot$ $H_2O$,
1,10 Gew.-Teile
Citronensäure $\cdot$ $H_2O$,
1,50 Gew.-Teile
Hexandiol-(1,6),
10,00 Gew.-Teile
Di-Na-benzol-1,3-disulfonat,
1,00 Gew.-Teile
anionogenes Tensid - I (Na-Olefinsulfonat),
0,30 Gew.-Teile
anionogenes Tensid - II (Alkylbenzolsulfonat),
80,50 Gew.-Teile $H_2O$ dest.

Beispiel 4

Es wird folgende Einbrenngummierung eingesetzt:

2,00 Gew.-Teile
Polyvinylphosphonsäure,
10,00 Gew.-Teile
Pyromellitsäure,
4,00 Gew.-Teile
Trikaliumcitrat $\cdot$ $H_2O$,
1,10 Gew.-Teile
Citronensäure $\cdot$ $H_2O$,
1,50 Gew.-Teile
Hexandiol-(1,6),
0,05 Gew.-Teile
anionogenes Tensid (siehe Beispiel 2),
81,30 Gew.-Teile
$H_2O$ dest.

Beispiel 5

Es wird folgende Einbrenngummierung eingesetzt:

1,5 Gew.-Teile
Polyvinylmethylphosphinsäure,
12,0 Gew.-Teile
Di-Na-benzol-1,3-disulfonat,
85,5 Gew.-Teile
$H_2O$ dest.

**Patentansprüche**

1. Einbrenngummierung für bestrahlte und entwickelte Offsetdruckplatten mit einem Gehalt an a) Wasser, b) mindestens einem hydrophilen Polymeren und c) mindestens einer sich von einer organischen Säure ableitenden Komponente, dadurch gekennzeichnet, daß sie als Komponente c) mindestens eine wasserlösliche organische Carbon-, Sulfon- oder Phosphonsäure mit mindestens zwei Säurefunktionen aus der Gruppe Benzolcarbonsäuren, -sulfonsäuren, -phosphonsäuren und Alkanphosphonsäuren oder eines ihrer wasserlöslichen Salze enthält.

2. Einbrenngummierung nach Anspruch 1, dadurch gekennzeichnet, daß sie als Komponente c) eine Benzoldisulfonsäure, eine Benzolpolycarbonsäure mit 3 bis 6 Carboxylgruppen, eine Alkandiphosphonsäure von $C_1$ bis $C_3$, eine Carboxylgruppen aufweisende Alkandiphosphonsäure von $C_5$ bis $C_9$ und/oder eines ihrer wasserlöslichen Salze enthält.

3. Einbrenngummierung nach Anspruch 1 oder 2, dadurch gekennzeichnet, daß sie als Komponente c) Benzol-1,3-disulfonsäure, Benzol-1,2,4-tricarbonsäure, Benzol-1,2,4,5-tetracarbonsäure, Benzol-hexacarbonsäure, Methan-diphosphonsäure, 4,4-Diphosphonoheptan-1,7-disäure und/oder eines ihrer wasserlöslichen Salze enthält.

4. Einbrenngummierung nach einem der Ansprüche 1 bis 3, dadurch gekennzeichnet, daß sie als Komponente b) N-Polyvinyl-pyrrolidon-(2), Polyvinylmethylether, Copolymerisate mit einem Gehalt an Ethylen- und Maleinsäureanhydrideinheiten, Homo- oder Copolymerisate mit einem Gehalt an Vinylphosphonsäure-, Vinylmethylphosphinsäure- und/oder Acrylsäureinheiten und/oder ein Polyalkylenglykol enthält.

5. Einbrenngummierung nach einem der Ansprüche 1 bis 4, dadurch gekennzeichnet, daß sie 1 bis 50 Gew.-% an der Summe der Komponenten b) und c) enthält.

6. Einbrenngummierung nach Anspruch 5, dadurch gekennzeichnet, daß sie die Komponenten b) und c) im Gewichtsverhältnis von 1:1 bis 1:20 enthält.

7. Einbrenngummierung nach einem der Ansprüche 1 bis 6, dadurch gekennzeichnet, daß sie zusätzlich eine Hydroxypolycarbonsäure und/oder deren wasserlösliche Salze enthält.

8. Einbrenngummierung nach einem der Ansprüche 1 bis 7, dadurch gekennzeichnet, daß sie zusätzlich ein wasserlösliches Alkandiol mit mindestens 4 C-Atomen enthält.

9. Einbrenngummierung nach einem der Ansprüche 1 bis 8, dadurch gekennzeichnet, daß die Offsetdruckplatte ein mechanisch, chemisch und/oder elektrochemisch aufgerauhtes und gegebenenfalls anodisch oxidiertes Trägermaterial aus Aluminium oder einer seiner Legierungen aufweist.

10. Einbrenngummierung nach einem der Ansprüche 1 bis 9, dadurch gekennzeichnet, daß die Offsetdruckplatte vor der Bestrahlung und Entwicklung auf mindestens einer der Oberflächen ihres Trägermaterials vollflächig eine positivarbeitende Reproduktionsschicht mit einem Gehalt an 1,2-Naphthochinondiazid aufweist.

11. Verfahren zur Herstellung einer Offsetdruckform mit den Grundarbeitsstufen Bestrahlen, Entwickeln und Einbrennen einer Offsetdruckplatte, dadurch gekennzeichnet, daß die Offsetdruckplatte, nach dem Entwickeln und vor dem Einbrennen mit einer Einbrenngummierung gemäß Anspruch 1 behandelt wird.

## Claims

1. Burning-in gum for irradiated and developed offset-printing plates, which contains a) water, b) at least one hydrophilic polymer and c) at least one component derived from an organic acid, wherein component c) comprises at least one water-soluble organic carboxylic, sulfonic, or phosphonic acid having at least two acid functions and being selected from the group consisting of benzene carboxylic acids, benzene sulfonic acids, benzene phosphonic acids, and alkane phosphonic acids, or one of the water-soluble salts of these acids.

2. A burning-in gum as claimed in claim 1, wherein component c) comprises a benzene disulfonic acid, a benzene polycarboxylic acid having from 3 to 6 carboxyl groups, a $C_1$ to $C_3$ alkane diphosphonic acid, a carboxyl-group-containing $C_5$ to $C_9$ alkane diphosphonic acid, and/or one of the water-soluble salts of these acids.

3. A burning-in gum as claimed in claim 1 or 2, wherein component c) comprises benzene-1,3-disulfonic acid, benzene-1,2,4-tricarboxylic acid, benzene-1,2,4,5-tetracarboxylic acid, benzene hexacarboxylic acid, methane diphosphonic acid, 4,4-diphosphonoheptane-1,7-dioic acid and/or one of the water-soluble salts of these acids.

4. A burning-in gum as claimed in any of claims 1 to 3, wherein component b) comprises N-polyvinyl-pyrrolidone-(2), polyvinyl methylether, copolymers containing ethylene units and maleic anhydride units, homopolymers or copolymers containing vinyl phosphonic acid units, vinyl methyl phosphinic acid units and/or acrylic acid units and/or a polyalkylene glycol.

5. A burning-in gum as claimed in any of claims 1 to 4, which comprises from 1 to 50% by weight of the sum of components b) and c).

6. A burning-in gum as claimed in claim 5, which contains components b) and c) in a weight ratio from 1:1 to 1:20.

7. A burning-in gum as claimed in any of claims 1 to 6, which additionally contains a hydroxypolycarboxylic acid and/or the water-soluble salts thereof.

8. A burning-in gum as claimed in any of claims 1 to 7, which additionally contains a water-soluble alkanediol having at least 4 carbon atoms.

9. A burning-in gum as claimed in any of claims 1 to 8, wherein the offset-printing plate has a mechanically, chemically and/or electrochemically roughened and optionally anodically oxidized support material of aluminum or an aluminum alloy.

10. A burning-in gum as claimed in any of claims 1 to 9, wherein the offset-printing plate, prior to irradiation and development, is provided on at least one of the surfaces of its support material with an overall coating of a positive-working reproduction layer containing 1,2-naphthoquinone diazide.

11. Process for the production of an offset-printing forme, comprising the basic working steps of irradiating, developing, and burning-in an offset-printing plate, wherein the offset-printing plate, after development and prior to burning-in, is treated with a burning-in gum as claimed in claim 1.

**Revendications**

1. Composition de gommage par cuisson pour plaques d'impression offset irradiées et développées, contenant a) de l'eau, b) au moins un polymère hydrophile et c) au moins un composant dérivé d'un acide organique, caractérisée en ce qu'elle contient, en tant que composant c), au moins un acide carboxylique, sulfonique ou phosphonique organique soluble dans l'eau, comportant au moins deux fonctions acides, choisi parmi des acides benzènecarboxyliques, benzènesulfoniques, benzènephosphoniques et alcanephosphoniques ou un de leurs sels solubles dans l'eau.

2. Composition de gommage par cuisson selon la revendication 1, caractérisée en ce qu'elle contient, en tant que composant c), un acide benzènedisulfonique, un acide benzène-polycarboxylique ayant de 3 à 6 groupes carboxy, un acide alcanediphosphonique en $C_1$ à $C_3$, un acide alcanediphosphonique en $C_5$ à $C_9$ comportant des groupes carboxy et/ou un de leurs sels solubles dans l'eau.

3. Composition de gommage par cuisson selon la revendication 1 ou 2, caractérisée en ce qu'elle contient, en tant que composant c), de l'acide benzène-1,3-disulfonique, de l'acide benzène-1,2,4-tricarboxylique, de l'acide benzène-1,2,4,5-tétracarboxylique, de l'acide benzène-hexacarboxylique, de l'acide méthane-diphosphonique, de l'acide 4,4-diphosphono-heptane-1,7-dioïque et/ou un de leurs sels solubles dans l'eau.

4. Composition de gommage par cuisson selon l'une des revendications 1 à 3, caractérisée en ce qu'elle contient, en tant que composant b), de la N-polyvinylpyrrolidone-(2), du poly(éther vinylméthylique), des copolymères contenant des motifs éthylène et anhydride maléique, des homo- ou copolymères contenant des motifs acide vinylphosphonique, acide vinylméthylphosphinique et/ou acide acrylique, et/ou un polyalkylèneglycol.

5. Composition de gommage par cuisson selon l'une des revendications 1 à 4, caractérisée en ce qu'elle contient de 1 à 50 % en poids de la somme des composants b) et c).

6. Composition de gommage par cuisson selon la revendication 5, caractérisée en ce qu'elle contient les composants b) et c) en un rapport pondéral allant de 1:1 à 1:20.

7. Composition de gommage par cuisson selon l'une des revendications 1 à 6, caractérisée en ce qu'elle contient en outre un acide hydroxypolycarboxylique et/ou ses sels solubles dans l'eau.

8. Composition de gommage par cuisson selon l'une des revendications 1 à 7, caractérisée en ce qu'elle contient en outre un alcanediol soluble dans l'eau, ayant au moins 4 atomes de carbone.

9. Composition de gommage par cuisson selon l'une des revendications 1 à 8, caractérisée en ce que la plaque d'impression offset comporte un matériau de support en aluminium ou en un de ses alliages, grainé mécaniquement, chimiquement et/ou électrochimiquement et éventuellement oxydé par anodisation.

10. Composition de gommage par cuisson selon l'une des revendications 1 à 9, caractérisée en ce que, la plaque d'impression offset comporte, avant l'irradiation et le développement, en totalité sur au moins l'une des surfaces de son matériau de support, une couche de reproduction travaillant en positif contenant un 1,2-naphtoquinonediazide.

11. Procédé de fabrication d'une forme d'impression offset comprenant les étapes de travail essentielles d'irradiation, développement et cuisson d'une plaque d'impression offset, caractérisé en ce que la plaque d'impression offset est traitée, après le développement et avant la cuisson, à l'aide d'une composition de gommage par cuisson selon la revendication 1.